# EUROPEAN PATENT SPECIFICATION

(11) **EP 3 758 136 B1**
(45) Date of publication and mention of the grant of the patent: **14.12.2022**
(21) Application number: 18912043.9
(22) Date of filing: 30.03.2018
(51) Int. Cl.: H01P 5/02, H01L 23/66, H05K 1/02, H01L 23/498, H01L 23/00, H05K 1/11

(54) **ELECTRONIC CIRCUIT**
ELEKTRONISCHE SCHALTUNG
CIRCUIT ÉLECTRONIQUE

(43) Date of publication of application: 30.12.2020
(73) Proprietor: Mitsubishi Electric Corporation, Tokyo 100-8310 (JP)
(72) Inventor: WATANABE, Motomi, Tokyo 100-8310 (JP)
(74) Representative: Pfenning, Meinig & Partner mbB
(86) International application number: PCT/JP2018/013634
(87) International publication number: WO 2019/187013

(56) References cited:
- WO-A1-2018/029846
- JP-A- 2004 146 810
- JP-A- 2017 121 032
- JP-B1- 6 234 645
- US-A1- 2005 190 614
- US-A1- 2017 005 047

## Description

### Technical Field

The present invention relates to an electronic circuit having a configuration in which two substrates are stacked so as to be connected to each other.

### Background Art

In recent years, in an electronic circuit, two substrates manufactured separately are stacked each other, and those two substrates are connected to each other. Flip chip mounting is a typical example of such a connection method, and has an advantage in that a mounting area can be reduced.

When the electronic circuit manufactured as described above handles a high-frequency signal, a stub is sometimes provided for impedance matching (see, for example, Patent Literature 1 and Patent Literature 2). This stub is to be connected to a signal transmission path. Patent Literature 3 also describes a stub connected to a transmission line and grounded within a semiconductor device, while Patent Literature 4 describes a stub grounded on a second substrate. Patent Literature 5 describes structures to connect high-frequency circuitry in multilayered substrates through via holes.

### Citation List

### Patent Literature

[PTL 1] JP 2013-098888 A
[PTL 2] JP 2012-520652 A
[PTL 3] US 2017/005047 A1
[PTL 4] JP 6 234645 B1
[PTL 5] US 2005/190614 A1

### Summary of Invention

### Technical Problem

As the stub, hitherto, a stub formed of a strip line is arranged on a surface on an outer side of a multilayer substrate (see, for example, FIG. 1 and FIG. 2 of Patent Literature 1 and FIG. 18 of Patent Literature 2). However, when the stub is arranged on the surface on the outer side of the multilayer substrate, an area that can be used for connection in the surface on the outer side of the multilayer substrate is reduced. When a required area cannot be ensured, the multilayer substrate is required to have a larger size. In the multilayer substrate, high-density mounting is usually performed. Further, when the stub is connected to the surface on the outer side, unnecessary radiation is caused.

The present invention has been made to solve the above-mentioned problems, and has an object to provide an electronic circuit that allows more suppression of upsizing and unnecessary radiation to be caused by a short-circuit stub.

### Solution to Problem

An electronic circuit according to the present invention is assumed to have a configuration in which a first substrate and a second substrate are stacked so as to be connected to each other, and the electronic circuit includes: a transmission path configured to connect a first wiring line for a signal and a second wiring line for a signal to each other, the first wiring line being formed in the first substrate, the second wiring line being formed in the second substrate; a short-circuit stub configured to connect a ground conductor provided on the first substrate and the transmission path to each other through use of three or more types of conductors; wherein the second substrate is a multilayer substrate, and the short-circuit stub includes, as the three or more types of conductors, a third wiring line for connection on a layer included in the second substrate, a columnar conductor for connection between layers, and a solder bump.

### Advantageous Effects of Invention

The present invention allows more suppression of upsizing of, and unnecessary radiation in the electronic circuit, which are caused by the short-circuit stub.

### Brief Description of Drawings

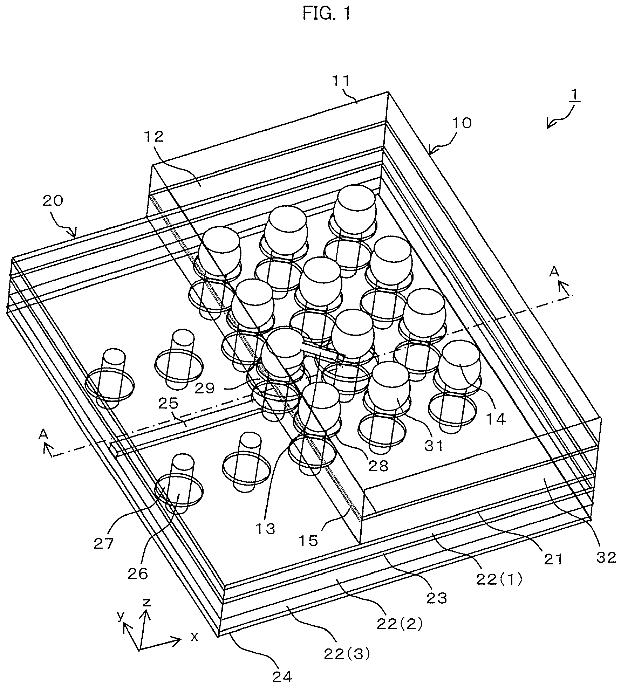

FIG. 1 is a perspective transparent view for illustrating an electronic circuit according to a first embodiment of the present invention.

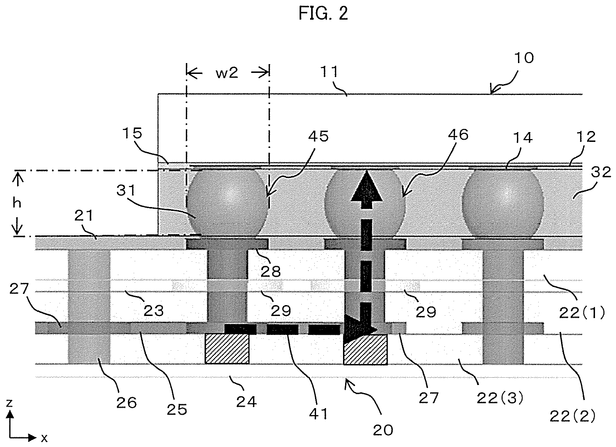

FIG. 2 is a side transparent view taken along the line A-A of FIG. 1 of the electronic circuit according to the first embodiment of the present invention.

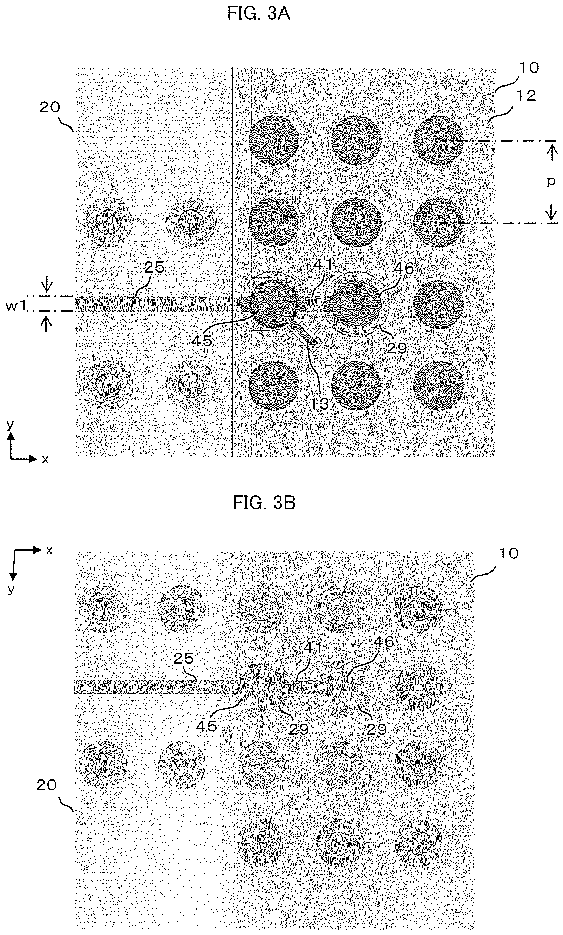

FIG. 3A is a top transparent view for illustrating the electronic circuit according to the first embodiment of the present invention.
FIG. 3B is a bottom transparent view for illustrating the electronic circuit according to the first embodiment of the present invention.

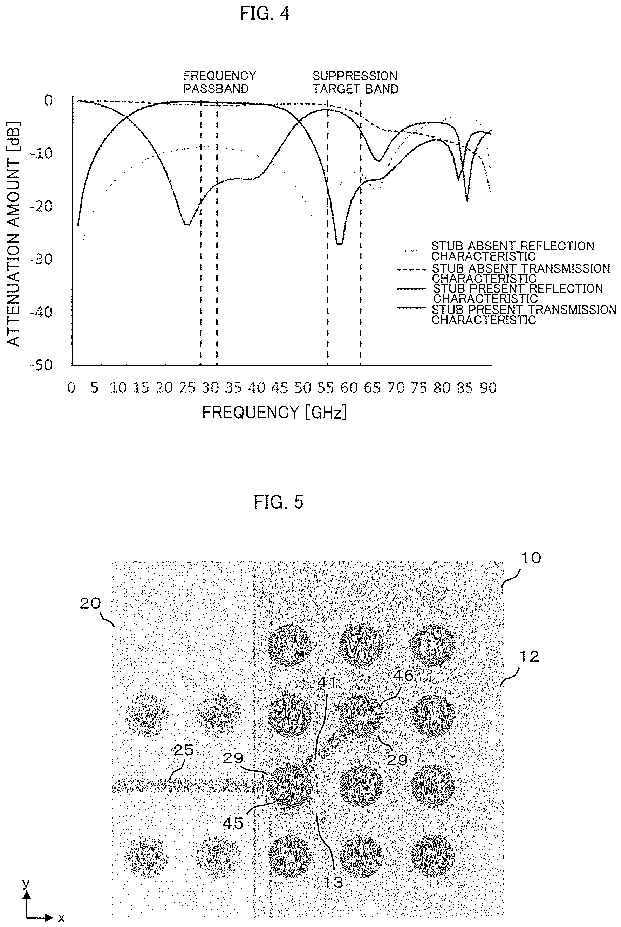

FIG. 4 is a graph for showing results of electromagnetic field analysis of a reflection characteristic and a transmission characteristic based on presence or absence of a short-circuit stub, which is performed with respect to the electronic circuit having the structure of FIG. 1.
FIG. 5 is a top transparent view for illustrating an electronic circuit according to a second embodiment of the present invention.

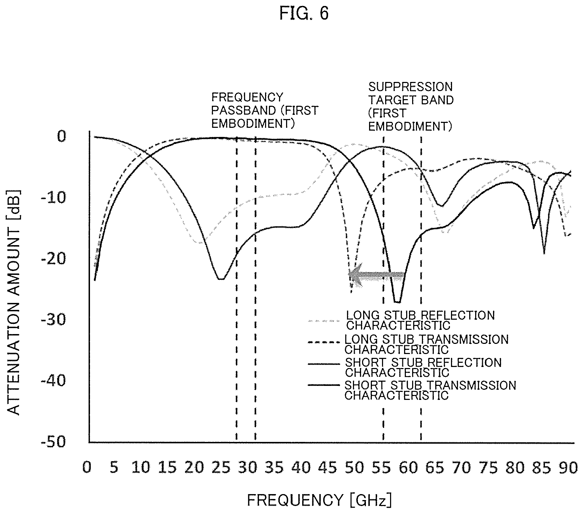

FIG. 6 is a graph for showing results of electromagnetic field analysis of the reflection characteristic and the transmission characteristic based on a length of the short-circuit stub, which is performed with respect to the electronic circuit having the structure of FIG. 1.

### Description of Embodiments

With reference to the drawings, embodiments of an electronic circuit according to the present invention are described below.

### First Embodiment

FIG. 1 is a perspective transparent view for illustrating an electronic circuit according to a first embodiment of the present invention. FIG. 2 is a side transparent view taken along the line A-A of FIG. 1 of the electronic circuit according to the first embodiment of the present invention. With reference to FIG. 1 and FIG. 2, description is specifically given of a configuration of an electronic circuit 1 according to the first embodiment.

In FIG. 1, three axes of xyz are illustrated, and, in FIG. 2, two axes of xz are illustrated. In the following, unless otherwise noted, a positional relationship and the like are expressed assuming a three-dimensional coordinate using those xyz axes. In this case, for example, in the z axis, a positive direction side indicates an upper side. A surface positioned on the positive direction side is expressed as "upper surface", and a surface opposing the upper surface is expressed as "lower surface". Surfaces other than the upper surface and the lower surface are all "side surfaces".

As illustrated in FIG. 1 and FIG. 2, for example, the electronic circuit 1 is manufactured using flip chip mounting in which a first substrate 10 is stacked on a second substrate 20 along the z-axis direction and connected thereto. The first substrate 10 and the second substrate 20 are connected to each other through use of solder bumps 31.

The first substrate 10 is, for example, a semiconductor chip. Throughout a lower surface of a layer 11 included in the first substrate 10, as illustrated in FIG. 1 and FIG. 2, a dielectric body 15 is formed. On a lower surface of the dielectric body 15, an earth conductor 12, a coplanar line 13, and a plurality of pads 14 are formed. The earth conductor 12 is a planar pattern to be connected to the ground. The coplanar line 13 is provided for signal transmission. The coplanar line 13 is connected to one of the pads 14. On a lower side of each of the pads 14, the solder bump 31 being connected to the corresponding pad 14 is arranged. The earth conductor 12 corresponds to a ground conductor described in the scope of claims.

The other second substrate 20 is a multilayer substrate in which a first layer 22(1) to a third layer 22(3) are laminated. On an upper surface of the first layer 22(1), a large number of lands 28 are formed, and a dielectric body 21 is formed in a part in which the lands 28 are absent. The solder bumps 31 are arranged on the lands 28, respectively. A space between the second substrate 20 and the first substrate 10 is filled with a dielectric body 32.

In FIG. 1, for the sake of easy understanding, the inside of each outline representing the solder bump 31, the pad 14, or the coplanar line 13 is non-transparent. In FIG. 2, for similar reasons, parts of the third layer 22(3) positioned below a first transmission structure 45 and a second transmission structure 46 are illustrated as hatched rectangles. With this illustration, it is clearly shown that a via 26 included in the first transmission structure 45 and a via 26 included in the second transmission structure 46 are both formed so as to pass through only the first layer 22(1) and the second layer 22(2), and are absent in the third layer 22(3). In the hatched rectangular parts, there are provided vias 26 included in structures adjacent to the first transmission structure 45 and the second transmission structure 46 on the positive direction side of the y axis. In FIG. 2, the coplanar line 13 is not shown due to the presence of the earth conductor 12.

The material of the layer 11 is, for example, silicon. The material of each of the first layer 22(1) to the third layer 22(3) is, for example, MEGTRON 6. The dielectric body 15 is, for example, polyimide. The dielectric body 32 is, for example, an adhesive called underfill. The dielectric body 21 is, for example, a resist. Each of the materials is not particularly limited.

On an upper surface of the second layer 22(2), that is, between the second layer 22(2) and the first layer 22(1), an earth conductor 23 is formed. The earth conductor 23 is a planar pattern connected to the ground. An upper surface of the third layer 22(3), that is, a space between the third layer 22(3) and the second layer 22(2) is used for a wiring line for signal transmission. In FIG. 1 and FIG. 2, a strip line 25 is illustrated as the wiring line therefor. On a lower surface of the third layer 22(3), an earth conductor 24 is formed. The earth conductor 24 is a planar pattern connected to the ground.

In the second substrate 20, a large number of vias 26 are formed. The vias 26 are columnar conductors for connection between layers. On a lower side of each land 28 formed on the upper surface of the first layer 22(1), the via 26 being connected to the corresponding land 28 is arranged. Each of the vias 26 is connected to a corresponding one of lands 27 formed on the upper surface of the third layer 22(3).

The strip line 25 is connected to one of the lands 27, and the corresponding land 27 is connected to one of the vias 26. The upper side of the corresponding via 26 is connected to the land 28, and one of the solder bumps 31 is arranged on the corresponding land 28. The pad 14 is arranged on the corresponding solder bump 31. In the following, for the sake of convenience, those land 27, via 26, land 28, solder bump 31, and pad 14 are collectively expressed as "first transmission structure 45".

The first transmission structure 45 has a space between the second layer 22(2) and the first layer 22(1), which corresponds to an inside of a hole 29. The hole 29 is structure for avoiding connection to the earth conductor 23 formed on the upper surface of the second layer 22(2). With this structure, the first transmission structure 45 is unconnected to the earth conductor 23.

The first transmission structure 45 is connected to a different via 26 via a strip line 41 and a different land 27. In the following, the corresponding different land 27, the corresponding different via 26, the land 28 arranged on the corresponding different via 26, the solder bump 31 arranged on the corresponding land 28, and the pad 14 arranged on the corresponding solder bump 31 are collectively expressed as "second transmission structure 46". A combination including the land 27, the via 26, the land 28, the solder bump 31, and the pad 14 other than those of the first transmission structure 45 and the second transmission structure 46 is simply expressed as "structure".

The second transmission structure 46 also has a space between the second layer 22(2) and the first layer 22(1), which corresponds to the inside of the hole 29. With this structure, the second transmission structure 46 is also unconnected to the earth conductor 23.

As illustrated in FIG. 1, the pad 14 included in the first transmission structure 45 and the coplanar line 13 connected to the corresponding pad 14 are not connected to the earth conductor 12 formed in the first substrate 10. Meanwhile, the pad 14 included in the second transmission structure 46 and the pads 14 included in other structures are connected to the earth conductor 12. As illustrated in FIG. 1 and FIG. 2, the other structures are connected to the earth conductor 23, that is, are connected to the ground. Therefore, the strip line 41 and the second transmission structure 46 function as a short-circuit stub. The two arrows of FIG. 2 represent paths of signals to be transmitted from the first transmission structure 45 to the earth conductor 12 via the strip line 41 and the second transmission structure 46.

FIG. 3A is a top transparent view for illustrating the electronic circuit according to the first embodiment of the present invention. FIG. 3B is a bottom transparent view for illustrating the electronic circuit according to the first embodiment of the present invention.

As illustrated in FIG. 3A and FIG. 3B, the strip line 41 arranged between the first transmission structure 45 and the second transmission structure 46 is configured to connect those structures to each other through the shortest path. The structures including those first transmission structure 45 and second transmission structure 46 are arranged in matrix on an xy plane.

As illustrated in FIG. 3A and FIG. 3B, the second transmission structure 46 is positioned so that, on the xy plane, one structure is present between the second transmission structure 46 and the side surface of the first substrate 10, that is, a boundary of a range in which the first substrate 10 and the second substrate 20 overlap each other. Except for the first transmission structure 45, other structures around the second transmission structure 46 are all connected to the earth conductor 23. The second transmission structure 46 is arranged at a location having such a positional relationship for the purpose of preventing the strip line 41 from being arranged on a surface on an outer side of the second substrate 20 and achieving a large effect of suppressing unnecessary radiation from the other structures.

An electrical length of the short-circuit stub including the strip line 41 and the second transmission structure 46 is an accumulated value of electrical lengths of the strip line 41 and the second transmission structure 46. It is important to set the electrical length of the short-circuit stub to be half a wavelength of a frequency that is assumed as an unnecessary wave.

For example, when the first substrate 10 operates as an amplifier and generates a second harmonic wave of an operation frequency as an unnecessary wave, in order to suppress the unnecessary wave of the second harmonic wave, it is important to set the electrical length of the short-circuit stub to be a length corresponding to the operation frequency.

For example, when the electronic circuit 1 is designed under the assumption that a frequency passband is from 27.5 GHz to 31 GHz and a frequency band for suppressing the second harmonic wave is from 55 GHz to 62 GHz, a pitch p between the structures of FIG. 3A is 500 µm, and a line width w1 of the strip line 25 is 85 µm. The dielectric constant is 11.9 in the layer 11 of the first substrate 10, and 3.62 in each of the first layer 22(1) to the third layer 22(3) of the second substrate 20. Further, the solder bump 31 is sized so that a height h of FIG. 2 is about 250 µm and a width w2 is about 300 µm.

FIG. 4 is a graph for showing results of electromagnetic field analysis of a reflection characteristic and a transmission characteristic based on presence or absence of the short-circuit stub, which is performed with respect to the electronic circuit having the structure of FIG. 1. In FIG. 4, the horizontal axis represents frequency, and the vertical axis represents attenuation amount. The lines with a notation of "STUB PRESENT" all correspond to the analysis results in the first embodiment. In FIG. 4, the frequency passband and a suppression target band, which is a band corresponding to a target of suppression, are indicated by broken lines.

Regarding the reflection characteristic, as shown in FIG. 4, when the short-circuit stub is present, as compared to a case in which the short-circuit stub is absent, improvement is achieved by 10 dB or more in the frequency passband, and 15 dB or more in the suppression target band. Regarding the transmission characteristic, as shown in FIG. 4, when the short-circuit stub is present, as compared to the case in which the short-circuit stub is absent, slight improvement is achieved in the frequency passband, and improvement is achieved by 20 dB or more in the suppression target band. It has been confirmed based on those results that the short-circuit stub in the first embodiment allows great improvement in both of the reflection characteristic and the transmission characteristic.

In the first embodiment, the via 26 serving as the columnar conductor is used as a part of the short-circuit stub. When this via 26 is used, as compared to a case in which the strip line to be used as a short-circuit stub is formed on the surface on the outer side of the substrate, the length of the strip line 41 can be reduced. When the length of the strip line 41 is thus reduced, the upsizing of the electronic circuit 1 caused when the short-circuit stub is provided can be avoided, or can be greatly suppressed. Further, radiation of an unnecessary wave from the short-circuit stub is suppressed. Around the second transmission structure 46, structures connected to the ground are arranged. Therefore, radiation of an unnecessary wave is further suppressed.

### Second Embodiment

In the above-mentioned first embodiment, the structure arranged nearest to the first transmission structure 45 is the second transmission structure 46. In contrast, in a second embodiment of the present invention, a different structure is used as the second transmission structure. In this case, reference symbols used in the above-mentioned first embodiment are used as they are so that description is given in a way focusing only on parts different from the above-mentioned first embodiment.

FIG. 5 is a top transparent view for illustrating an electronic circuit according to the second embodiment of the present invention. In the second embodiment, as illustrated in FIG. 5, the structure to be connected to the first transmission structure 45 is a structure adjacent to the above-mentioned second transmission structure 46 on the positive direction side of the y axis. Similarly to the above-mentioned first embodiment, the second transmission structure 46 in the second embodiment has a space between the second layer 22(2) and the first layer 22(1), which corresponds to the inside of the hole 29, and is thus unconnected to the earth conductor 23. The structure arranged at the position of the second transmission structure 46 in the above-mentioned first embodiment is connected to the earth conductor 23.

FIG. 6 is a graph for showing results of electromagnetic field analysis of the reflection characteristic and the transmission characteristic based on a length of the short-circuit stub, which is performed with respect to the electronic circuit having the structure of FIG. 1. Also in FIG. 6, similarly to FIG. 4, the horizontal axis represents frequency, and the vertical axis represents attenuation amount. The lines with a notation of "LONG STUB" all correspond to the analysis results in the second embodiment. The lines with a notation of "SHORT STUB" all correspond to the analysis results in the above-mentioned first embodiment. Thus, in FIG. 6, the analysis results of the above-mentioned first embodiment and the second embodiment are shown.

As illustrated in FIG. 5, when the position of the second transmission structure 46 is changed, along with the change, the length of the strip line 41 is increased as compared to that in the above-mentioned first embodiment. Therefore, as shown in FIG. 6, frequency bands in which the reflection characteristic and the transmission characteristic are greatly improved are both moved to a lower frequency side. It can be confirmed based on those results that, even with the short-circuit stub using the second transmission structure 46, the frequency passband and the suppression target band can be changed by adjusting the electrical length.

In the above-mentioned first embodiment and the above-mentioned second embodiment, the short-circuit stub is structured to include five types of conductors, specifically, the strip line 41 for connection on a layer, the via 26, the lands 27 and 28, the solder bump 31, and the pad 14. However, the types used in the short-circuit stub and the combination of those types are not limited to the above. Further, the number of conductors used in each type is not limited to those in the above-mentioned first embodiment and the above-mentioned second embodiment. For example, a plurality of strip lines 41 and a plurality of vias 26 may be used. In view of the above, the actual structure of the short-circuit stub can be modified in various ways.

Further, the strip line 25 is formed on the upper surface of the third layer 22(3). When the strip line 25 is formed at this position, as compared to a case in which the strip line 25 is formed on the surface on the outer side of the second substrate 20, that is, on the upper surface of the first layer 22(1) or the lower surface of the third layer 22(3), radiation of an electromagnetic wave from the strip line 25 can be suppressed. Further, the following advantages can be obtained. Specifically, the via 26 can be easily used as the short-circuit stub, and troubles due to direct connection of the strip line 41 are less liable to occur.

### Reference Signs List

1 electronic circuit, 10 first substrate, 11 layer, 12, 23, 24 earth conductor, 20 second substrate, 14 pad, 22(1) first layer, 22(2) second layer, 22(3) third layer, 25, 41 strip line, 26 via, 27, 28 land, 29 hole, 45 first transmission structure, 46 second transmission structure.

## Claims

1. An electronic circuit (1), in which a first substrate (10) and a second substrate (20) are stacked and connected to each other, the electronic circuit comprising:
a transmission path (14, 26 to 28, 31) configured to connect a first wiring line (13) for a signal and a second wiring line (25) for a signal to each other, the first wiring line being formed in the first substrate, the second wiring line being formed in the second substrate; and
a short-circuit stub (41, 46) configured to connect a ground conductor (12) provided on the first substrate and the transmission path to each other through use of three or more types of conductors;
wherein the second substrate is a multilayer substrate, and
the short-circuit stub includes, as the three or more types of conductors, a third wiring line (41) for connection on a layer (22(3)) included in the second substrate, a columnar conductor (26) for connection between layers, and a solder bump (31).

2. The electronic circuit according to claim 1,
wherein the second wiring line is formed on a layer (22(3)) unexposed to an outer side of the second substrate, and
the third wiring line is connected to the second wiring line.

3. The electronic circuit according to claim 1 or 2,
wherein one or more other grounded columnar conductors (26) arranged around the columnar conductor included in the short-circuit stub.

4. The electronic circuit according to any one of claims 1 to 3,
wherein, in a range in which the first substrate and the second substrate overlap each other, the columnar conductor included in the short-circuit stub is arranged at a position where one or more different columnar conductors (26) are present between the columnar conductor and a boundary of the range in an orthogonal direction orthogonal to a direction in which the first substrate and the second substrate are stacked.

## Patentansprüche

1. Elektronische Schaltung (1), bei der ein erstes Substrat (10) und ein zweites Substrat (20) gestapelt und miteinander verbunden sind, wobei die elektronische Schaltung umfasst:
einen Übertragungspfad (14, 26 bis 28, 31), der eingerichtet ist, eine erste Verdrahtungsleitung (13) für ein Signal und eine zweite Verdrahtungsleitung (25) für ein Signal miteinander zu verbinden, wobei die erste Verdrahtungsleitung in dem ersten Substrat ausgebildet ist, und die zweite Verdrahtungsleitung in dem zweiten Substrat ausgebildet ist; und
eine Kurzschluss-Stichleitung (41, 46), die eingerichtet ist, einen Erdungsleiter (12), der auf dem ersten Substrat vorgesehen ist, und den Übertragungspfad durch Verwendung von drei oder mehr Typen von Leitern miteinander zu verbinden;
wobei das zweite Substrat ein Mehrschichtsubstrat ist, und
die Kurzschluss-Stichleitung als die drei oder mehr Typen von Leitern eine dritte Verdrahtungsleitung (41) zur Verbindung mit einer in dem zweiten Substrat enthaltenen Schicht (22(3)), einen säulenförmigen Leiter (26) zur Verbindung zwischen Schichten und einen Löthöcker (31) umfasst.

2. Elektronische Schaltung nach Anspruch 1,
wobei die zweite Verdrahtungsleitung auf einer Schicht (22(3)) ausgebildet ist, die zu einer Außenseite des zweiten Substrats hin nicht freigelegt ist, und
die dritte Verdrahtungsleitung mit der zweiten Verdrahtungsleitung verbunden ist.

3. Elektronische Schaltung nach Anspruch 1 oder 2,
wobei ein oder mehrere andere geerdete säulenförmige Leiter (26) um den säulenförmigen Leiter angeordnet sind, der in der Kurzschluss-Stichleitung enthalten ist.

4. Elektronische Schaltung nach einem der Ansprüche 1 bis 3,
wobei in einem Bereich, in dem das erste Substrat und das zweite Substrat einander überlappen, der in der Kurzschluss-Stichleitung enthaltene säulenförmige Leiter an einer Position angeordnet ist, an der ein oder mehrere unterschiedliche säulenförmige Leiter (26) zwischen dem säulenförmigen Leiter und einer Grenze des Bereichs in einer orthogonalen Richtung orthogonal zu einer Richtung, in der das erste Substrat und das zweite Substrat gestapelt sind, vorhanden sind.

## Revendications

1. Un circuit électronique (1), dans lequel un premier substrat (10) et un second substrat (20) sont empilés et connectés l'un à l'autre, le circuit électronique comprenant :
un chemin de transmission (14, 26 à 28, 31) configuré afin de connecter l'une à l'autre une première ligne de câblage (13) d'un signal et une deuxième ligne de câblage (25) d'un signal, la première ligne de câblage étant formée dans le premier substrat, la deuxième ligne de câblage étant formée dans le second substrat ; et
un stub à court-circuit (41, 46) configuré afin de connecter l'un à l'autre un conducteur de masse (12) disposé sur le premier substrat et le chemin de transmission, en utilisant trois types de conducteurs ou plus ;
dans lequel le second substrat est un substrat multicouche, et
le stub à court-circuit comprend, en tant que trois types de conducteurs ou plus, une troisième ligne de câblage (41) destinée à une connexion sur une couche (22(3)) incluse dans le second substrat, un conducteur cylindrique (26) destiné à une connexion entre des couches, et une perle de soudure (31).

2. Le circuit électronique selon la revendication 1,
dans lequel la deuxième ligne de câblage est formée sur une couche (22(3)) non exposée à un côté extérieur du second substrat, et
la troisième ligne de câblage est connectée à la deuxième ligne de câblage.

3. Le circuit électronique selon la revendication 1 ou 2,
dans lequel un ou plusieurs autres conducteurs cylindriques mis à la masse (26) sont agencés autour du conducteur cylindrique inclus dans le stub à court-circuit.

4. Le circuit électronique selon l'une quelconque des revendications 1 à 3,
dans lequel, dans une plage dans laquelle se chevauchent l'un l'autre le premier substrat et le second substrat, le conducteur cylindrique inclus dans l'adaptateur à court-circuit est agencé au niveau d'une position où un ou plusieurs conducteurs cylindriques (26) différents sont présents entre le conducteur cylindrique et une limite de la plage dans une direction orthogonale, orthogonale à la direction dans laquelle sont empilés le premier substrat et le second substrat.
